# EUROPEAN PATENT SPECIFICATION

(11) **EP 1 509 634 B1**
(45) Date of publication and mention of the grant of the patent: **24.08.2011**
(21) Application number: 02793568.3
(22) Date of filing: 30.12.2002
(51) Int. Cl.: C23C 16/00

(54) **SURFACE TREATMENT SYSTEM, SURFACE TREATMENT METHOD AND PRODUCT PRODUCED BY SURFACE TREATMENT METHOD**
OBERBLÄCHENBEHANDLUNGSSYSTEM, OBERFLÄCHENBEHANDLUNGSVERFAHREN UND DURCH OBERFLÄCHENBEHANDLUNGSVERFAHREN HERGESTELLTES PRODUKT
SYSTEME ET PROCEDE DE TRAITEMENT DE SURFACE ET PRODUIT OBTENU AU MOYEN DE CE PROCEDE

(30) Priority: 29.03.2002 KR 2002017509
(43) Date of publication of application: 02.03.2005
(73) Proprietor: LG Electronics, Inc., Seoul 150-010 (KR)
(72) Inventor: CHO, Cheon-Soo, 641-150 Changwon, Gyeongsangnam-Do (KR); YOUN, Dong-Sik, Gimhae, Gyeongsangnam-Do, Korea (KR); LEE, Hyun-Wook, 621-919 Gimhae, Gyeongsangnam-Do (KR); HA, Samchul, 641-775 Changwon, Gyeongsangnam-Do (KR); JUN, Hyun-Woo, 621-831 Gimhae, Geongsangnam-Do, Korea (KR)
(74) Representative: Schippan, Ralph
(86) International application number: PCT/KR2002/002491
(87) International publication number: WO 2003/083164

(56) References cited:
- US-A- 4 913 090
- PATENT ABSTRACTS OF JAPAN & JP 07 099 321 A (SONY CORP) 11 April 1995
- PATENT ABSTRACTS OF JAPAN & JP 10 200 211 A (SONY CORP) 31 July 1998
- PATENT ABSTRACTS OF JAPAN & JP 11 250 456 A (SHIMADZU CORP) 17 September 1999

## Description

### TECHNICAL FIELD

The present invention relates to a surface treatment of a product, and particularly, to a surface treatment system, a surface treatment method and a product produced by the surface treatment method.

### BACKGROUND ART

In general, a surface treatment is to make a surface of a product made of a material such as a metal look good, or to improve a surface to have heat resistance, corrosion resistance, abrasion resistance, etc. so that a function of the product can be improved according to a condition of usage of the product.

Meanwhile, a heat exchanger used in an air conditioner, a refrigerator, a heating device, etc. is a device for transmitting heat from fluid of high/low temperature to fluid of low/high temperature through a heat transmitting wall. A status of the surface on the heat transmitting wall greatly affects to the heat exchanging efficiency of the heat exchanger, such that the flowing of the fluid can be varied according to the status of the surface on the heat transmitting wall.

Therefore, it is necessary to improve properties of the surface on the heat transmitting wall so as to improve the heat exchanging efficiency, and accordingly, fins constructing the heat exchanger are produced by processing a sheet material having a surface which is treated to have hydrophilicity, hydrophobicity or corrosion resistance, etc.

In addition, the sheet material for manufacturing fins constructing the heat exchanger undergoes surface treatment process forming a deposition layer on the surface of the sheet material using a chemical vapor deposition reaction or a physical vapor deposition reaction.

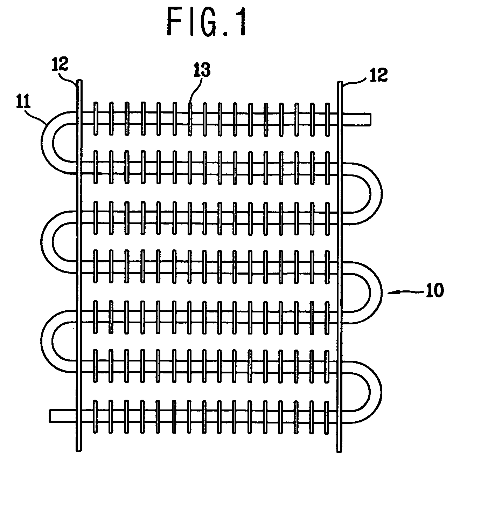

Figure 1 is a plane view showing a general heat exchanger used in a refrigerator.

As shown in Figure 1, the general heat exchanger used in the refrigerator as an example of the heat exchanger 10 comprises a refrigerant pipe 11 having a passage of refrigerant, a pair of fixing members 12 for fixing the refrigerant pipe 11, and a plurality of fins 13 fixedly installed on the refrigerant pipe 11 with some intervals therebetween for heat exchange.

The refrigerant in low temperature flowing on the refrigerant pipe 11 of the heat exchanger 10 cools down the air flowing on the surface of the heat exchanger 10, and the cooled air maintains temperatures of a cooling chamber or a freezing chamber of the refrigerator in preset temperature. Generally, dewdrops are generated on the surface of the heat exchanger 10 by cooling down the air, and the dewdrops on the surface of the heat exchanger 10 forms ices. Then, the ices are grow larger and larger to narrow the passage of the air and to reduce contacting area between the air and the surface of the heat exchanger 10, and thereby, efficiency of the refrigerator is lowered.

Therefore, the heat exchanger 10 uses a plurality of fins 13 after processing plate materials which are treated to have hydrophilicity to prevent the dewdrops from being stayed on the fin 13 of the heat exchanger 10, and thereby, the efficiency of the refrigerator can be improved.

However, during the process of fabricating the surface treated sheet materials into the fins for the heat exchanger, cut surface and the deposition layer may be damaged, or the fins are assembled some parts which are not treated may be generated and the dewdrops are generated on that parts.

That is, the member, which is surface treated to perform good function when it is used, may be damaged its surface in fabricating process such as molding fabrication or assembling fabrication to become a product, or the member may be assembled with other member of which surface is not treated, and accordingly, the function improvement effect of the product according to the surface treatment is reduced.

### DISCLOSURE OF THE INVENTION

Therefore, it is an object of the present invention to provide a surface treatment system and a surface treatment method by which a massive surface treatment is performed so that deposition layer can be formed on entire surfaces of members which are included in a product, by treating surfaces of a product including one or more members for forming the deposition layer.

To achieve the object of the present invention, there is provided a surface a surface treatment system comprising: a conveying unit for loading and conveying a heat exchanger; and a surface treatment unit for forming deposition layer on a surface of the heat exchanger conveyed by the conveying unit; wherein the heat exchanger comprises: a refrigerant pipe having a passage of refrigerant; and a plurality of heat transfer fins coupled to the refrigerant pipe.

Also, to achieve the object of the present invention, there is provided a surface treatment method comprising: a conveying step for loading and conveying a heat exchanger; and a deposition layer forming step for forming a deposition layer on a surface of the heat exchanger; wherein the heat exchanger comprises: a refrigerant pipe having a passage of refrigerant; and a plurality of heat transfer fins coupled to the refrigerant pipe.

### BRIEF DESCRIPTION OF THE DRAWINGS

Figure 1 is a plane view showing a general heat exchanger used in a refrigerator;
Figure 2 is a schematic view showing a structure of a surface treatment system according to the present invention; and
Figure 3 is a view showing a conveying path of a carrier in the surface treatment system in Figure 2.

### MODES FOR CARRYING OUT THE PREFERRED EMBODIMENTS

Hereinafter, a surface treatment system, a surface treatment method and a product produced by the surface treatment method according to the present invention will be described in detail with reference to accompanying Figures.

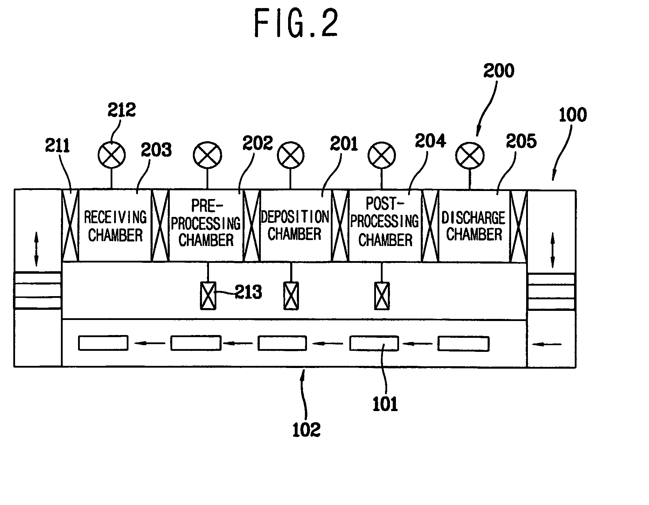

Figure 2 is a brief view showing a structure of the surface treatment system according to the present invention.

As shown therein, the surface treatment system according to the present invention comprises: a conveying unit 100 for loading and conveying a processed object of surface treatment constructed by one or more members; and a surface treatment unit 200 forming a deposition layer on surface of the object of surface treatment conveyed by the conveying unit 100.

The surface treatment unit 200 which forms the deposition layer on the surface of the object of surface treatment comprises a deposition chamber 201 for forming the deposition layer on the surface of the object of surface treatment.

A method for forming the deposition layer on the surface of the conveyed object of surface treatment can be divided into a method forming the deposition layer using a chemical vapor deposition (CVD) reaction, and a method forming the deposition layer using a physical vapor deposition (PVD) reaction.

The method forming the deposition layer using the CVD forms the deposition layer using plasma polymerization reaction, and the method forming the deposition layer using the PVD forms the deposition layer using a sputtering method, etc.

In the embodiment of the present invention, the method forming the deposition layer using the plasma polymerization method, which is a kind of CVD reaction, is used, but the PVD method also can be used.

That is, the deposition chamber 201 is sealed by a chamber opening/ closing means 211 and O-ring during the reaction, and a vacuum degree required by the deposition reaction is maintained using a pump 212. In addition, the deposition layer having a certain property, such as hydrophilicity, hydrophobicity or corrosion resistance, etc is formed on the surface of the object of surface treatment using the plasma polymerization reaction generated by injecting reaction gas into the deposition chamber 201 and applying electric power to electrodes (not shown) installed in the deposition chamber 201. Also, a plurality of deposition chambers 201 for different surface treatments may be constructed as needed.

The surface treatment unit 200 further includes a preprocessing chamber 202 for preprocessing the surface of the object of surface treatment before the deposition layer is formed on the surface of the object of surface treatment, and may include additionally a receiving chamber 203 for receiving a carrier 101 on which the object of surface treatment is mounted.

Also, the surface treatment unit 200 further includes a post-processing chamber 204 for post-processing the surface of the object of surface treatment on which the deposition layer is formed, and may include additionally a discharge chamber 205 for discharging the carrier 101 on which the object of surface treatment is mounted.

Meanwhile, the receiving chamber 203, the preprocessing chamber 202, the deposition chamber 201, the post-processing chamber 204 and the discharge chamber 205 constructing the surface treatment unit are sequentially disposed and opened/closed by chamber opening/closing means respectively. And the chambers are sealed by a sealing means such as O-ring.

The conveying unit 100 comprises a carrier 101 for loading the object of surface treatment, and a conveying device 102 for conveying the carrier 101.

The carrier 101 may be plural, and the carrier 101 coveys the object of surface treatment loaded thereon along with a conveying path of the conveying unit 100 sequentially.

The conveying device 102 uses a driving device such as a motor and a guide, and moves the carrier 101 sequentially along with the conveying path.

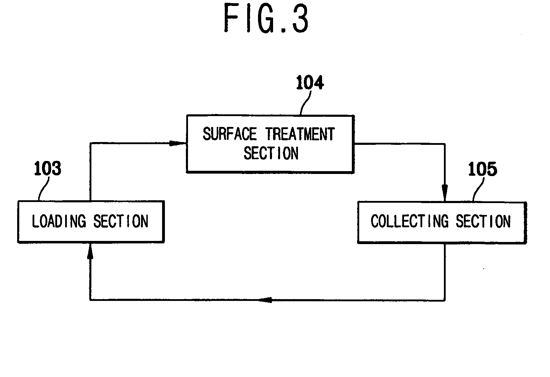

Figure 3 is a view showing the convey path of the carrier in the surface treatment system according to the present invention.

As shown therein, the convey path, on which the carrier is moved, comprises a loading section 103 on which the object of surface treatment is loaded on the carriers 101, a surface treatment section 104 positioned on the surface treatment unit 200 and connected to the loading section 103, and a collecting section 105 connected between the surface treatment section 104 and the loading section 103 for collecting the object of surface treatment loaded on the carriers 101.

Meanwhile, operations of the surface treatment system according to the present invention having above structure will be described as follows.

To begin with, the object of surface treatment in the present invention is a product processed using one or more members, and the processing method can be divided into an assembling fabrication, a molding fabrication, or a mechanical fabrication etc.

Also, the object of surface treatment is not a member which is processed as a product after forming the deposition layer on the surface of the member, but a product processed using one or more members.

Also, the object of surface treatment is generally a metal material, and especially, a heat exchanger used in a refrigerator and in an air conditioner can be an example of the object of surface treatment.

That is, fins which are processed to be used in the heat exchanger, or the heat exchanger 10 comprising a refrigerant pipe 11 having a passage of refrigerant and a plurality of fins 13 coupled to the refrigerant pipe can be the object of surface treatment.

Also, the deposition layer formed on the object of surface treatment is able to have various properties such as hydrophilicity, hydrophobicity, corrosion resistance, heat resistance, abrasion resistance, etc. according to conditions that the object of surface treatment is used.

Operations of the surface treatment system having above structure will be described as follows. The object of surface treatment is loaded on a plurality of carriers 101 moving sequentially and continuously in the loading section 103. And the carriers 101 are moved continuously and sequentially by the conveying device 102.

The object of surface treatment loaded on the carriers 101 comes to the surface treatment section 104 according to the movement of the carriers 101, and passes the receiving chamber 203 and undergoes the preprocessing for forming the deposition layer in the preprocessing chamber 202, such as cleaning, etc..

The object of surface treatment which is pre-processed in the preprocessing chamber 202 is moved to the deposition chamber 201 by the movement of the carriers 101, and the deposition layer is formed on the surface of the object of surface treatment by a deposition reaction which is set advance so that the deposition layer of required properties can be formed.

The object of surface treatment on which the deposition layer is formed is moved to the post-processing chamber 204 by the movement of the carriers 101, and undergoes a process after forming the deposition layer in the post-processing chamber 204, and then, comes into the collecting section 105 as passing the discharge chamber 205.

The respective chambers are sealed by using opening/closing means (not shown) and sealing means (not shown) after the carriers 101 come in, and then, is opened by using the opening/closing means after the respective processes are completed, to move the carriers 101.

The object of surface treatment which reaches to the collecting section 105 by the movement of the carriers 101 is collected by an additional device or an added collecting device, and thereby, the surface treatment processes for making the surface properties suitable for the usage condition are completed.

Also, the carriers 101 having no object of surface treatment are moved to the loading section 103 by the conveying device 102 again to load another object of surface treatment, and moved toward the surface treatment section again, and thereby, the surface treatment processes are performed continuously.

That is, the massive surface treatments can be performed continuously as repeating the above processes. Also, the surface treatment system comprises a controlling device to control the respective processes.

Meanwhile, the present invention provides a surface treatment method for treating a surface of a product fabricated using one or more members. And the surface treatment method according to the present invention comprises a conveying step for loading and conveying a product which is produced by fabricating one or more members, and a deposition layer forming step for forming the deposition layer on a surface of the conveyed product using the deposition reaction.

The surface treatment method may further comprises a fabrication step for producing the product by coupling a plurality of members before the conveying step. The fabrication step is a step fabricating a product by coupling a plurality of members by assembling, mechanical fabrication or molding.

The conveying step comprises a loading step for loading the product on the carriers, and a carrier conveying step for conveying the carriers. The conveying path of the carriers comprises a loading section for loading the product on the carriers, a surface treatment section installed on the surface treatment unit and connected to the loading section, and a collecting section connected between the surface treatment section and the loading section for collecting the product loaded on the carriers. The plurality of carriers are conveyed continuously and sequentially.

Also, a preprocessing step for preprocessing the surface of the product can be added before the deposition layer forming step, and a post-processing step for post-processing the product on which the deposition layer is formed can be added after the deposition layer forming step.

According to the present invention, the massive surface treatment can be performed so that the deposition layer can be formed on the entire surfaces of the members consisting of the product by treating the surface of the product comprising one or more members for forming the deposition layer continuously, and thereby, the surface treatment system according to the present invention is able to improve a productivity.

Also, the deposition layer damage which may be generated in the fabrication process of the product can be prevented by treating the surface of the fabricated product. In addition, the product can be suitable for the conditions more easily by treating the entire surface of the product.

Especially, advantages of the present invention can be identified by comparing to following comparative example.

### Comparative example

The heat exchanger comprising the fins and the refrigerant pipe used in the refrigerator shown in Figure 1 was used as the object of surface treatment. Ratios of the fins and the refrigerant pipe for entire heat transfer area were 85% and 15% in entire heat transmitting area, respectively.

Water was sprayed to the heat exchanger having the fins which was fabricated using the surface treated member to have hydrophilicity, and to the heat exchanger which was surface treated by the surface treatment system according to the present invention, and then, water amount remained on the surfaces of the heat exchangers are measured after 5 minutes had passed.

There was 57g of remained water in case of the heat exchanger having the fins fabricated using the surface treated member, and there was 37g of remained water in case of the heat exchanger which was surface treated to be hydrophilic by the surface treatment system according to the present invention.

Therefore, the product which is surface treated by the surface treatment system according to the present invention can suit to the usage condition more effectively than that of the conventional art.

## Claims

1. A surface treatment system comprising:
a conveying unit for loading and conveying a heat exchanger; and
a surface treatment unit for forming deposition layer on a surface of the heat exchanger conveyed by the conveying unit; wherein the heat exchanger comprises:
a refrigerant pipe having a passage of refrigerant; and
a plurality of heat transfer fins coupled to the refrigerant pipe.

2. The system of claim 1, wherein the conveying unit comprises:
a carrier for loading the heat exchanger; and
a conveying device for conveying the carrier.

3. The system of claim 1, wherein the conveying unit further comprises a conveying path for conveying the carrier.

4. The system of claim 3, wherein the conveying path comprises:
a loading section for loading the heat exchanger on the carrier;
a surface treatment section installed on the surface treatment unit and connected to the loading section; and
a collecting section connected between the surface treatment section and the loading section for collecting the heat exchanger loaded on the carrier.

5. The system of claim 2, wherein the carrier is constructed to be plural, and conveyed continuously and sequentially.

6. The system of claim 1, wherein the surface treatment unit comprises a deposition chamber for forming the deposition layer on the surface of the heat exchanger using CVD reaction.

7. The system of claim 6, wherein the surface treatment unit further includes a preprocessing chamber for preprocessing the surface of the heat exchanger before the deposition layer is formed on the surface of the heat exchanger.

8. The system of claim 7, wherein the preprocessing chamber further includes a receiving chamber for receiving the carrier on which the heat exchanger.

9. The system of claim 6, wherein the surface treatment unit further comprises a post-processing chamber for post-processing the surface of the heat exchanger on which the deposition layer is formed.

10. The system of claim 9, wherein the post-processing chamber further includes a discharge chamber for discharging the carrier on which the post-processed heat exchanger is loaded.

11. A surface treatment method comprising:
a conveying step for loading and conveying a heat exchanger; and
a deposition layer forming step for forming a deposition layer on a surface of the heat exchanger; wherein the heat exchanger comprises:
a refrigerant pipe having a passage of refrigerant; and
a plurality of heat transfer fins coupled to the refrigerant pipe.

12. The method of claim 11, wherein the deposition layer is formed using a chemical vapor deposition (CVD) reactions.

13. The method of claim 12, wherein the CVD reaction is a plasma polymerizing reaction.

14. The method of claim 11, wherein the deposition layer is formed using a physical vapor deposition (PVD) reaction.

15. The method of any of claims 11-14, further comprising a processing step for producing the heat exchanger by coupling a plurality of members before the conveying step.

16. The method of claim 15, wherein the heat exchanger is produced by coupling the plurality of members using assembling process.

17. The method of claim 15, wherein the heat exchanger is processed by mechanical process.

18. The method of claim 15, wherein the heat exchanger is processed by molding process.

19. The method of claim 15, wherein the members are metal materials.

20. The method of claim 11, wherein the deposition layer forming step forms the deposition layer having hydrophilicity on a surface of the heat exchanger.

21. The method of claim 11, wherein the deposition layer forming step forms the deposition layer having hydrophobicity on a surface of the heat exchanger.

22. The method of claim 11, wherein the deposition layer forming step forms the deposition layer having corrosion resistance on a surface of the heat exchanger.

23. The method of claim 11, wherein the conveying step comprises:
a loading step for loading the heat exchanger on a carrier; and
a carrier conveying step for conveying the carrier.

24. The method of claim 23, wherein the carrier is constructed to be plural, and conveyed continuously and sequentially.

25. The method of claim 11, further comprising a preprocessing step for preprocessing the surface of the heat exchanger before the deposition layer forming step.

26. The method of claim 11, further comprising a post-processing step for post-processing the surface of the heat exchanger on which the deposition layer is formed after the deposition layer forming step.

## Patentansprüche

1. Oberflächenbehandlungssystem mit:
einer Fördereinheit zum Laden und Fördern eines Wärmetauschers; und
einer Oberflächenbehandlungseinheit zum Ausbilden einer Abscheidungsschicht auf einer Oberfläche des Wärmetauschers, der durch die Fördereinheit gefördert wird;
wobei der Wärmetauscher umfasst:
ein Kühlmittelrohr, das einen Kühlmittelkanal aufweist; und
mehrere Wärmeübertragungsrippen, die an das Kühlmittelrohr gekoppelt sind.

2. System nach Anspruch 1, wobei die Fördereinheit umfasst:
einen Träger zum Laden des Wärmetauschers; und
eine Fördervorrichtung zum Fördern des Trägers.

3. System nach Anspruch 1, wobei die Fördereinheit ferner eine Förderungsstrecke zum Fördern des Trägers umfasst.

4. System nach Anspruch 3, wobei die Förderungsstrecke umfasst:
einen Ladeabschnitt zum Laden des Wärmeaustauschers auf den Träger;
einen Oberflächenbehandlungsabschnitt, der auf der Oberflächenbehandlungseinheit installiert und mit der Ladeabteilung verbunden ist; und
einen Sammelabschnitt, der zwischen dem Oberflächenbehandlungsabschnitt und dem Ladeabschnitt eingebunden ist, für das Sammeln des auf dem Träger geladenen Wärmeaustauschers.

5. System nach Anspruch 2, wobei der Träger ausgelegt ist, vielfach zu sein und kontinuierlich und nacheinander gefördert zu werden.

6. System nach Anspruch 1, wobei die Oberflächenbehandlungseinheit eine Abscheidekammer für das Ausbilden der Abscheidungsschicht auf der Oberfläche des Wärmetauschers unter Verwendung von CVD-Reaktion umfasst.

7. System nach Anspruch 6, wobei die Oberflächenbehandlungseinheit ferner eine Vorverarbeitungskammer für die Vorverarbeitung der Oberfläche des Wärmetauschers vor dem Ausbilden der Abscheidungsschicht auf der Oberfläche des Wärmetauschers enthält.

8. System nach Anspruch 7, wobei die Vorverarbeitungskammer ferner eine Aufnahmekammer für die Aufnahme des Trägers enthält, auf dem der Wärmetauscher ist.

9. System nach Anspruch 6, wobei die Wärmebehandlungseinheit ferner eine Nachbearbeitungskammer für die Nachbearbeitung der Oberfläche des Wärmetauschers umfasst, auf der die Abscheidungsschicht ausgebildet ist.

10. System nach Anspruch 9, wobei die Nachbearbeitungskammer ferner eine Entladungskammer für das Entladen des Trägers enthält, auf dem der nachbearbeitete Wärmetauscher geladen ist.

11. Oberflächenbehandlungsverfahren mit:
einem Förderungsschritt zum Laden und Fördern eines Wärmetauschers; und
einem Abscheidungsschicht-Ausbildungsschritt zum Ausbilden einer Abscheidungsschicht auf einer Oberfläche des Wärmetauschers, wobei der Wärmetauscher umfasst:
ein Kühlmittelrohr, das einen Kühlmittelkanal aufweist; und
mehrere Wärmeübertragungsrippen, die an das Kühlmittelrohr gekoppelt sind.

12. Verfahren nach Anspruch 11, wobei die Abscheidungsschicht unter Verwendung der Reaktionen einer chemischen Gasphasenabscheidung (CVD) ausgebildet ist.

13. Verfahren nach Anspruch 12, wobei die CVD-Reaktion eine Plasmapolymerisierungsreaktion ist.

14. Verfahren nach Anspruch 11, wobei die Abscheidungsschicht unter Verwendung der Reaktion einer physikalischen Gasphasenabscheidung (PVD) ausgebildet ist.

15. Verfahren nach einem der Ansprüche 11 - 14, ferner umfassend einen Verarbeitungsschritt zum Herstellen des Wärmetauschers durch Koppeln mehrerer Elemente vor dem Förderungsschritt.

16. Verfahren nach Anspruch 15, wobei der Wärmetauscher durch Koppeln mehrerer Elemente unter Verwendung eines Montagevorgangs erzeugt ist.

17. Verfahren nach Anspruch 15, wobei der Wärmetauscher durch einen mechanischen Vorgang bearbeitet ist.

18. Verfahren nach Anspruch 15, wobei der Wärmetauscher durch einen Formgebungsvorgang bearbeitet ist.

19. Verfahren nach Anspruch 15, wobei die Elemente Metallmaterialien sind.

20. Verfahren nach Anspruch 11, wobei der Abscheidungsschicht-Ausbildungsschritt die Abscheidungsschicht, die eine Hydrophilie aufweist, auf einer Oberfläche des Wärmetauschers ausbildet.

21. Verfahren nach Anspruch 11, wobei der Abscheidungsschicht-Ausbildungsschritt die Abscheidungsschicht, die eine Hydrophobie aufweist, auf einer Oberfläche des Wärmetauschers ausbildet.

22. Verfahren nach Anspruch 11, wobei der Abscheidungsschicht-Ausbildungsschritt die Abscheidungsschicht, die eine Korrosionsbeständigkeit aufweist, auf einer Oberfläche des Wärmetauschers ausbildet.

23. Verfahren nach Anspruch 11, wobei der Förderungsschritt umfasst:
einen Ladeschritt für das Laden des Wärmetauschers auf einem Träger; und
einen Trägerförderungsschritt für das Fördern des Trägers.

24. Verfahren nach Anspruch 23, wobei der Träger ausgelegt ist, vielfach zu sein und kontinuierlich und nacheinander gefördert zu werden.

25. Verfahren nach Anspruch 11, ferner umfassend einen Vorbearbeitungsschritt für das Vorbearbeiten der Oberfläche des Wärmetauschers vor dem Abscheidungsschicht-Ausbildungsschritt.

26. Verfahren nach Anspruch 11, ferner umfassend einen Nachbearbeitungsschritt für das Nachbearbeiten der Oberfläche des Wärmetauschers, auf dem die Abscheidungsschicht nach dem Abscheidungsschicht-Ausbildungsschritt ausgebildet ist.

## Revendications

1. Système de traitement de surface comprenant:
une unité de transport destinée à charger et à transporter un échangeur thermique ; et
une unité de traitement de surface destinée à former une couche de dépôt sur une surface de l'échangeur thermique transporté par l'unité de transport; dans lequel l'échangeur thermique comprend:
un tuyau de réfrigérant ayant un passage de réfrigérant; et
une pluralité d'ailettes de transfert thermique couplées au tuyau de réfrigérant.

2. Système selon la revendication 1, dans lequel l'unité de transport comprend:
un support pour charger l'échangeur thermique; et
un dispositif de transport pour transporter le support.

3. Système selon la revendication 1, dans lequel l'unité de transport comprend en outre un chemin de transport pour transporter le support.

4. Système selon la revendication 3, dans lequel le chemin de transport comprend :
une section de chargement pour charger l'échangeur thermique sur le support;
une section de traitement de surface installée sur l'unité de traitement de surface et reliée à la section de chargement ; et
une section de collecte reliée entre la section de traitement de surface et la section de chargement pour collecter l'échangeur thermique chargé sur le support.

5. Système selon la revendication 2, dans lequel le support est constitué pour être multiple et transporté de manière continue et séquentielle.

6. Système selon la revendication 1, dans lequel l'unité de traitement de surface comprend une chambre de dépôt pour former la couche de dépôt sur la surface de l'échangeur thermique en utilisant une réaction de dépôt chimique en phase vapeur (CVD).

7. Système selon la revendication 6, dans lequel l'unité de traitement de surface comprend en outre une chambre de prétraitement destinée au prétraitement de la surface de l'échangeur thermique avant la formation de la couche de dépôt sur la surface de l'échangeur thermique.

8. Système selon la revendication 7, dans lequel la chambre de prétraitement comprend en outre une chambre de réception destinée à recevoir le support sur lequel se trouve l'échangeur thermique.

9. Système selon la revendication 6, dans lequel l'unité de traitement de surface comprend en outre une chambre de post-traitement destinée au post-traitement de la surface de l'échangeur thermique sur laquelle la couche de dépôt est formée.

10. Système selon la revendication 9, dans lequel la chambre de post-traitement comprend en outre une chambre de décharge pour décharger le support sur lequel l'échangeur thermique post-traité est chargé.

11. Procédé de traitement de surface comprenant :
une étape de transport destinée à charger et à transporter un échangeur thermique; et
une étape de formation de couche de dépôt destinée à former une couche de dépôt sur une surface de l'échangeur thermique; dans lequel l'échangeur thermique comprend :
un tuyau de réfrigérant ayant un passage de réfrigérant; et
une pluralité d'ailettes de transfert thermique couplées au tuyau de réfrigérant.

12. Procédé selon la revendication 11, dans lequel la couche de dépôt est formée en utilisant des réactions de dépôt chimique en phase vapeur (CVD).

13. Procédé selon la revendication 12, dans lequel la réaction CVD est une réaction de polymérisation de plasma.

14. Procédé selon la revendication 11, dans lequel la couche de dépôt est formée en utilisant une réaction de dépôt physique en phase vapeur (PVD).

15. Procédé selon l'une quelconque des revendications 11 à 14, comprenant en outre une étape de traitement pour produire l'échangeur thermique en couplant une pluralité d'éléments avant l'étape de transport.

16. Procédé selon la revendication 15, dans lequel l'échangeur thermique est produit en couplant la pluralité d'éléments en utilisant un procédé d'assemblage.

17. Procédé selon la revendication 15, dans lequel l'échangeur thermique est traité par un procédé mécanique.

18. Procédé selon la revendication 15, dans lequel l'échangeur thermique est traité par un procédé de moulage.

19. Procédé selon la revendication 15, dans lequel les éléments sont des matériaux métalliques.

20. Procédé selon la revendication 11, dans lequel l'étape de formation de couche de dépôt forme la couche de dépôt étant hydrophile sur une surface de l'échangeur thermique.

21. Procédé selon la revendication 11, dans lequel l'étape de formation de couche de dépôt forme la couche de dépôt étant hydrophobe sur une surface de l'échangeur thermique.

22. Procédé selon la revendication 11, dans lequel l'étape de formation de couche de dépôt forme la couche de dépôt étant résistante à la corrosion sur une surface de l'échangeur thermique.

23. Procédé selon la revendication 11, dans lequel l'étape de transport comprend:
une étape de chargement destinée à charger l'échangeur thermique sur un support; et
une étape de transport de support destinée à transporter le support.

24. Procédé selon la revendication 23, dans lequel le support est constitué pour être multiple et transporté de manière continue et séquentielle.

25. Procédé selon la revendication 11, comprenant en outre une étape de prétraitement destinée au prétraitement de la surface de l'échangeur thermique avant l'étape de formation de couche de dépôt.

26. Procédé selon la revendication 11, comprenant en outre une étape de post-traitement destinée au post-traitement de la surface de l'échangeur thermique sur laquelle la couche de dépôt est formée après l'étape de formation de couche de dépôt.
